# EUROPÄISCHE PATENTSCHRIFT

(11) **EP 3 308 181 B1**
(45) Veröffentlichungstag und Bekanntmachung des Hinweises auf die Patenterteilung: **28.10.2020**
(21) Anmeldenummer: 16732993.7
(22) Anmeldetag: 15.06.2016
(51) Int. Cl.: G01R 31/36, H01M 8/18, H02M 1/32, H02H 7/12, H02M 3/158, H02J 7/00

(54) **REDOX-FLOW-BATTERIESYSTEM UND VERFAHREN ZUM ERKENNEN EINES FEHLERS IN EINER BRÜCKENSCHALTUNG EINES DC/DC-WANDLERS EINES REDOX-FLOW-BATTERIESYSTEMS**
REDOX-FLOW BATTERY SYSTEM AND METHOD FOR DETECTING A FAULT IN A BRIDGE CIRCUIT OF A DC/DC-CONVERTER OF A REDOX-FLOW BATTERY SYSTEM
SYSTÈME DE BATTERIE RÉDOX ET PROCÉDÉ DE DÉTECTION D'UN DÉFAUT DANS UN CIRCUIT EN PONT D'UN CONVERTISSEUR CC-CC D'UN SYSTÈME DE BATTERIE RÉDOX

(30) Priorität: 15.06.2015 DE 102015210920
(43) Veröffentlichungstag der Anmeldung: 18.04.2018
(73) Patentinhaber: TRUMPF Hüttinger GmbH + Co. KG, 79111 Freiburg (DE)
(72) Erfinder: KAUFMANN, Jens, 79102 Freiburg (DE); LUETH, Thomas, 79104 Freiburg (DE)
(74) Vertreter: Kohler Schmid Möbus Patentanwälte
(86) Internationale Anmeldenummer: PCT/EP2016/063722
(87) Internationale Veröffentlichungsnummer: WO 2016/202844

(56) Entgegenhaltungen:
- CN-A- 102 437 628
- CN-A- 103 326 437
- CN-A- 104 539 187
- JP-A- 2007 137 093
- JP-A- 2010 093 952
- JP-A- 2011 045 240
- KR-A- 20140 080 567
- US-A- 5 659 237
- US-A1- 2002 109 467
- US-A1- 2012 112 545

## Beschreibung

Die Erfindung betrifft ein Redox-Flow-Batteriesystem mit einer Steuerung und einem Batteriewechselrichter, der geeignet ist, einen Batterie zu laden und/oder zu entladen.

Weiterhin betrifft die Erfindung ein Verfahren zum Erkennen eines Fehlers in einer Brückenschaltung eines DC/DC-Wandlers eines erfindungsgemäßen Redox-Flow-Batteriesystems.

Die US 2012/0112545A1 offenbart ein modulares mehrstufiges Konvertersystem, welches eine Vielzahl von in Serie miteinander verbundenen mehrstufigen Konverterzellen aufweist. Wenigstens eine der modularen mehrstufigen Konverterzellen ist eine dreistufige modulare Konverterzelle. Eine Vielzahl von in Serie verbundenen modularen mehrstufigen Konverterzellen sind über einen DC-Bus mit einem Gleichrichtersystem verbunden. Eine Zelle kann über einen DC/DC-Wandler mit einer Batterie verbunden sein.

Die CN 104539187A offenbart einen AC/DC-Konverter und einen DC-Resonanzkonverter.

Die JP 2011045240A offenbart einen bidirektionalen DC/DC-Wandler.

Aus der KR 20140080567A ist ein Batteriebetriebssystem und ein Verfahren zum Betrieb eines solchen Systems bekannt.

Die CN 103326437A offenbart einen Ladeschaltkreis, um eine Batterie zu laden. Außerdem ist eine Schutzschaltung vorgesehen. Jeder Lade- und Schutzschaltkreis umfasst einen Ladeschaltkreis und eine Schaltung zur Erfassung von Spannung, Strom und Temperatur.

Die JP 2007137093A offenbart einen Tiefsetzsteller, der zwischen einer Last und einer Batterie angeordnet ist.

Redox-Flow-Batterien, die beispielsweise Elektrolyt-Kombinationen von V/V, Fe/Cr oder Zn/Br verwenden, werden im zunehmenden Maße als stationäre Energiespeicher verwendet. Integriert in ein großes System aus Energieerzeugern und -verbrauchern dienen diese zur Netzstabilisierung oder können Erzeuger- oder Lastspitzen abfangen.

Ein solches Batteriesystem ist beispielsweise in US 8,723,489 beschrieben. Solche Batterien sind in der Regel an eine Leistungselektronik zum Laden und/oder Entladen angeschlossen. Die Leistungselektronik kann dabei einen Wechselrichter umfassen. Bei einem Defekt in der Leistungselektronik auf Seiten der Batterie treibt die Batterie einen großen Kurzschlussstrom in die Leistungselektronik, was zu einer Zerstörung dieser führt und letztendlich auch zu einem Brand führen kann.

Aufgabe der vorliegenden Erfindung ist es, ein Redox-Flow-Batteriesystem vorzuschlagen, mit dem diese Nachteile vermieden werden können und außerdem ein Verfahren zum Erkennen eines Fehlers in einer Brückenschaltung eines DC/DC-Wandlers eines Redox-Flow-Batteriesystems bereit zu stellen, mit dem die oben genannten Nachteile vermieden werden können.

Gelöst wird diese Aufgabe gemäß Anspruch 1 durch ein Redox-Flow-Batteriesystem mit einer Steuerung und einem Batteriewechselrichter, der geeignet ist, eine Batterie zu laden und/oder zu entladen, wobei der Batteriewechselrichter umfasst:
a. Mehrere Batterieanschlüsse, an die jeweils zumindest eine Batterie anschließbar ist;
b. Eine erste Messeinrichtung, die geeignet ist, die Spannung an einem Batterieanschluss zu messen und die mit der Steuerung signaltechnisch verbunden ist;
c. Eine zweite Messeinrichtung, die geeignet ist, den Strom an einem Batterieanschluss zu messen und die mit der Steuerung signaltechnisch verbunden ist;
d. Einen Netzanschluss, der an ein Wechselstromversorgungsnetz anschließbar ist, wobei
e. der Batteriewechselrichter mehrere DC/DC-Wandler aufweist, von denen zumindest einer eine direkt mit einem Batterieanschluss verbundene erste Brückenschaltung aufweist, wobei die Steuerung ausgelegt ist, die Brückenschaltung abzuschalten, wenn bei einer Überwachung des Stroms und der Spannung der entsprechende Stromverlauf und/oder der entsprechende Spannungsverlauf ein vorgegebenes Muster zeigen, welches eindeutig auf einen Defekt oder einen Fehler in der Brückenschaltung hinweist. Eine Batterie kann ein Zelle oder ein Zellenverbund, z.B. ein Flow-Batterie-Stack oder mehrere Flow-Batterie-Stacks einer Flow-Batterie sein. Ein Flow-Batterie-Stack kann typischerweise aus 20 oder 40 Zellen bestehen. Eine Batterie kann demnach als Stack bestehend aus mehreren Flow-Batterie-Zellen ausgebildet sein. Bei der erfindungsgemäßen Anordnung kann über die erste und zweite Messeinrichtung ein Fehler im Batteriewechselrichter, insbesondere in der Brückenschaltung erkannt werden. Dadurch, dass die Brückenschaltung direkt an der Batterie angeordnet ist, kann die Brückenschaltung abgeschaltet werden. Insbesondere kann der Stromfluss von einer Hochspannungsseite zur Batterie sicher getrennt werden. Dadurch ergibt sich ein insgesamt sicheres System.

Die erste Brückenschaltung kann eine Primärwicklung eines Übertragers umfassen, wobei ein Kondensator oder eine Spule in Reihe zu der Primärwicklung und/oder ein Kondensator in Reihe zu der Sekundärwicklung des Übertragers geschaltet ist. Dieser Kondensator verbessert sowohl die Sicherheit bei einem Kurzschluss eines Schalters der Brückenschaltung an der Batterie, weil er einen Gleichstrom verhindert, und außerdem verbessert er die Effizienz der Gesamtanordnung, da er bewirkt, dass die Schalter der Brückenschaltung in einem günstigen Zeitpunkt (Null-Volt-Schalten) ein- bzw. ausgeschaltet werden. Besonders bevorzugt ist es, wenn jeweils ein Kondensator kann auf beiden Seiten des Übertragers angeordnet ist.

Die Sekundärwicklung des Übertragers kann Bestandteil einer zweiten Brückenschaltung sein. Insbesondere kann der Batteriewechselrichter eine hochspannungsseitige Brückenschaltung und eine batterieseitige, niederspannungsseitige Brückenschaltung aufweisen. Durch den Übertrager kann eine Transformation von der Niederspannungsseite zur Hochspannungsseite erfolgen. Das Übertragungsverhältnis kann beispielsweise 1:12 betragen.

Der zumindest eine DC/DC-Wandler der zweiten Brückenschaltung kann nachgeordnet einen Hoch-/Tiefsetzsteller (Buck Boost Converter) aufweisen. Dadurch kann die Spannung am Ausgang der zweiten Brückenspaltung an der Ausgangsseite des Wechselrichters erhöht werden.

Die Steuerung kann so ausgelegt sein, dass anhand der durch die erste und zweite Messeinrichtung gemessenen Spannung und Strom ein Fehler in der ersten Brückenschaltung erkannt werden kann und diese bei Fehlererkennung abgeschaltet werden kann. Somit kann die Sicherheit des Redox-Flow-Batteriesystems erhöht werden und kann ein Brand vermieden werden. Insbesondere kann das Gesamtsystem in einen sicheren Zustand überführt werden. Insbesondere können die Gatetreiber der Schalter einer Brückenschaltung so angesteuert werden, dass die Brückenschaltung ausgeschaltet wird. Je nach Dimensionierung können die Schalter der Brückenschaltung einen Kurzschlussstrom für eine kurze Zeit tragen und eine weitere Zerstörung und ein Brand können vermieden werden. Sicherungen können grundsätzlich vorgesehen sein. Allerdings reagieren diese unter Umständen zu langsam, um den Batteriewechselrichter zu schützen. Die erfindungsgemäße Anordnung bietet daher einen größeren Schutz.

In den Rahmen der Erfindung fällt außerdem ein Verfahren gemäß Anspruch 9 zum Erkennen eines Fehlers in einer Brückenschaltung eines DC/DC-Wandlers eines erfindungsgemäßen Redox-Flow-Batteriesystems, bei dem Strom und Spannung an einem Batterieanschluss überwacht werden und bei Eintritt eines vorgegebenen Ereignisses die an den Batterieanschluss angeschlossene Brückenschaltung abgeschaltet wird. Durch diese Maßnahme kann eine Zerstörung des Batteriewechselrichters vermieden werden und kann ein Brand verhindert werden.

Strom und/oder Spannung können hinsichtlich des Erreichens eines Schwellwerts überwacht werden. Dass demnach ein Schwellwert erreicht, spricht dies dafür, dass ein Fehler in der Brückenschaltung aufgetreten ist, beispielsweise ein Kurzschluss entstanden ist. In diesem Fall kann eine Brückenschaltung schnell abgeschaltet werden.

Der Strom und/oder die Spannung kann hinsichtlich des Auftretens eines vorgegebenen Musters überwacht werden. Das Muster kann sich im Laufe der Zeit auch ändern. Insbesondere kann das vorgegebene Muster selbstlernend bestimmt werden. Wenn demnach der Stromverlauf und/oder der Spannungsverlauf ein bestimmtes Muster zeigt, und dieses Muster für das Auftreten eines Fehlers spricht, kann auch in diesem Fall die Brückenschaltung abgeschaltet werden. Insbesondere können charakteristische Verläufe gespeichert sein, die eindeutig auf einen Defekt (Kurzschluss oder Unterbrechung) hinweisen. Wird ein solcher charakteristischer Verlauf erkannt, können die Schalter entsprechend angesteuert werden und das System in einen sicheren Zustand gebracht werden. Wenn mehrere DC/DC-Wandler in einem Batteriewechselrichter vorgesehen sind, kann nur der betroffene Zweig, d.h. nur der Zweig, in dem ein fehlerhafter DC/DC-Wandler erkannt wurde, ausgeschaltet werden.

Insbesondere kann vorgesehen sein, dass ein Fehler erkannt wird, wenn ein Spannungseinbruch detektiert wird. Beispielsweise kann ein Spannungseinbruch in der Batteriespannung auftreten, wenn ein Kurzschluss an einem ersten Schalter einer Brückenschaltung auftritt.

Anhand der gemessenen Strom und/oder Spannung kann bestimmt werden, welcher der Transistoren der Brückenschaltung fehlerhaft ist. Somit kann die Brückenschaltung gezielt angesteuert werden, um weitere Fehler und unsichere Zustände zu vermeiden. Gegebenenfalls kann aufgrund der Erfassung, welcher der Transistoren der Brückenschaltung fehlerhaft ist, ein gezielter Austausch stattfinden. Das Redox-Flow-Batteriesystem kann mit geringerer Leistung mit den nicht fehlerhaften Brückenschaltungen weiter betrieben werden.

Die Brückenschaltung kann abgeschaltet werden, indem Gatetreiber, die Transistoren der Brückenschaltung zugeordnet sind, abgeschaltet werden. Dadurch kann eine besonders schnelle Abschaltung einer Brückenschaltung erfolgen.

Weitere Merkmale und Vorteile der Erfindung ergeben sich aus der nachfolgenden Beschreibung eines Ausführungsbeispiels der Erfindung, anhand der Figuren der Zeichnung, die erfindungswesentliche Einzelheiten zeigen, und aus den Ansprüchen. Die einzelnen Merkmale können je einzeln für sich oder zu mehreren in beliebiger Kombination bei einer Variante der Erfindung verwirklicht sein.

Bevorzugte Ausführungsbeispiele der Erfindung sind in der Zeichnung schematisch dargestellt und werden nachfolgend mit Bezug auf die Figuren der Zeichnungen näher erläutert. Es zeigen:
- Fig. 1: stark schematisiert ein Redox-Flow-Batteriesystem ;
- Fig. 2: eine detaillierte Darstellung eines DC/DC-Wandlers;
- Fig. 3: charakteristische Spannungs- und Stromverläufe, die für das Auftreten eines Fehlers in einer Brückenschaltung sprechen;
- Fig. 4: weitere charakteristische Strom- und Spannungsverläufe, die für einen Fehler in einer Brückenschaltung sprechen.

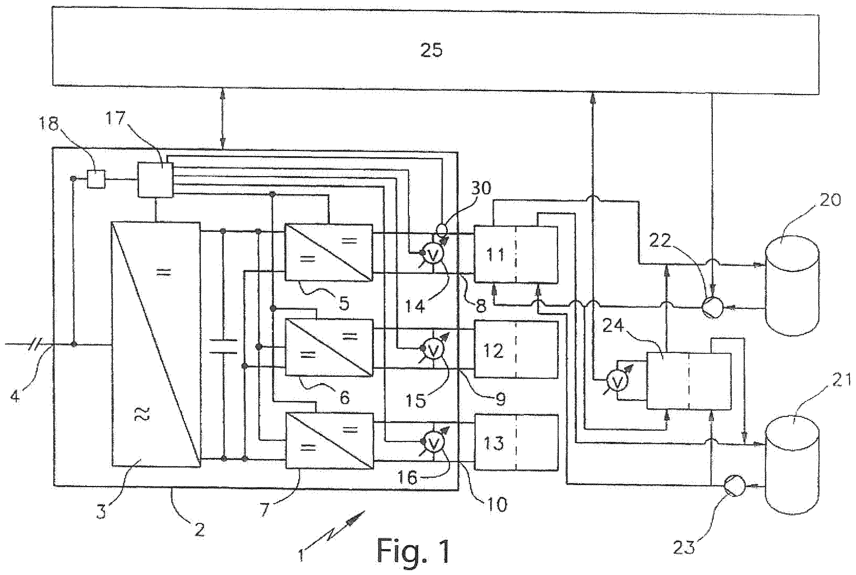

Die Fig. 1 zeigt ein Redox-Flow-Batteriesystem 1 mit einem bidirektionalen Wechselrichter 2. Der bidirektionale Wechselrichter 2 umfasst einen AC/DC-Wandler 3, der mit einem Netzanschluss 4 des Wechselrichters 2 verbunden ist. An den AC/DC-Wandler sind im gezeigten Ausführungsbeispiel drei DC/DC-Wandler 5 bis 7 angeschlossen, die jeweils an einen Batterieanschluss 8 bis 10 des Wechselrichters 2 angeschlossen sind. An die Batterieanschlüsse 8 bis 10 ist jeweils eine Batterie 11 bis 13 angeschlossen. Die Batterien 11 bis 13 können tatsächlich als Stacks bestehend aus mehreren Flow-Batterie-Zellen ausgebildet sein. An den Batterieanschlüssen 8 bis 10 sind jeweils erste Messeinrichtungen 14 bis 16 angeordnet, mit denen die Spannung an den Batterieanschlüssen 8 bis 10 überwacht bzw. erfasst werden kann. Dadurch wird gleichzeitig die Spannung an den Batterien 11 bis 13 überwacht. Damit kann dann auch der Ladezustand (bei Leerlauf) ermittelt werden. Dieser kann mit der Referenzzelle 24 verglichen werden und auf eine Alterung der Batterie geschlossen werden. Die ersten Messeinrichtungen 14 bis 16 sind mit einer Steuerung 17 signaltechnisch verbunden. Die Steuerung 17 ist weiterhin signaltechnisch mit dem AC/DC-Wandler 3 und den DC/DC-Wandlern 5 bis 7 verbunden. Die Steuerung 17 wird durch eine Hilfsstromversorgung 18 mit Leistung versorgt. Die Stromversorgung 18 ist im Ausführungsbeispiel mit dem Netzanschluss 4 verbunden.

Weiterhin weist jeder Batterieanschluss 8, 9, 10 eine zweite Messeinrichtung 30 auf, die zur Strommessung am Batterieanschluss 8, 9, 10 dient. In der Fig. 1 ist nur exemplarisch eine zweite Messeinrichtung 30 für den Batterieanschluss 8 eingezeichnet. Die Batterieanschlüsse 9, 10 weißen jedoch ebenfalls entsprechende zweite Messeinrichtungen auf.

Das Redox-Flow-Batteriesystem umfasst Elektrolyt-Tanks 20, 21. Pumpen 22, 23 können Elektrolyt aus den Elektrolyt-Tanks 20, 21 zu den Batterien 11 bis 13 pumpen. Hierfür ist ein entsprechendes Leitungssystem vorgesehen. Im gezeigten Ausführungsbeispiel ist - um die Übersichtlichkeit zu wahren - nur das Leitungssystem gezeigt, mit dem die Batterie 11 versorgt wird. Weiterhin ist eine Messzelle 24 gezeigt, die zur Ladezustandsüberwachung dienen kann.

Das Redox-Flow-Batteriesystem 1 weist weiterhin eine übergeordnete Steuerung 25 auf, mit der nicht nur der Wechselrichter 2, sondern auch beispielsweise die Pumpen 22, 23 gesteuert werden können. Die übergeordnete Steuerung 25 könnte auch im Wechselrichter 2 angeordnet sein. Insbesondere könnte sie in der Steuerung 17 angeordnet sein. Alternativ wäre es denkbar, die Steuerung 17 in die übergeordnete Steuerung 25 zu integrieren.

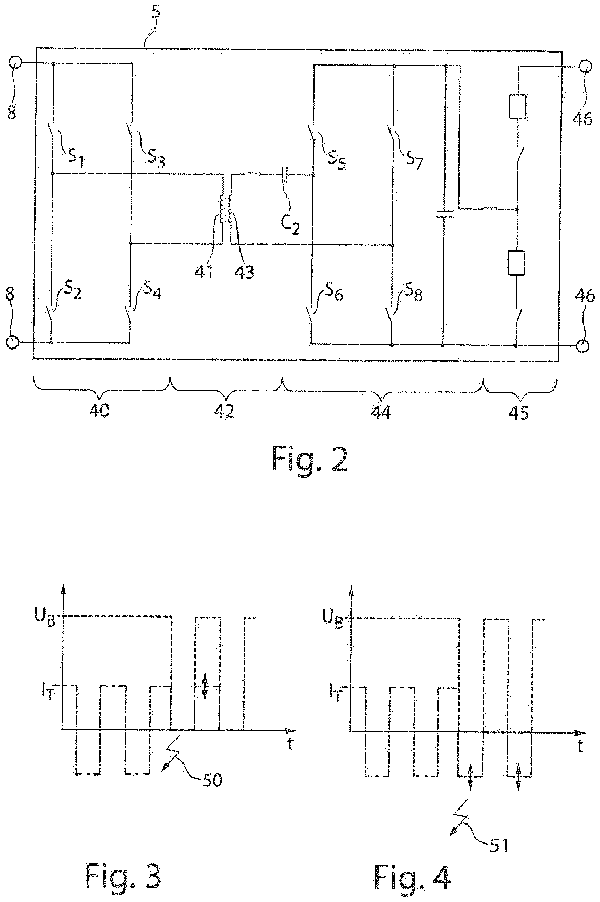

Die Fig. 2 zeigt eine Ausgestaltung des DC/DC-Wandlers (5), wobei die DC/DC-Wandler 6, 7 entsprechend ausgebildet sind. Bei der Darstellung der Fig. 2 ist der Batterieanschluss 8 des DC/DC-Wandlers 5 links dargestellt. An den Batterieanschluss 8 ist eine niederspannungsseitige Brückenschaltung 40 angeschlossen, die vier als Transistoren ausgebildete schaltende Elemente S1, S2, S3 und S4 aufweist. Die Brückenschaltung 40 ist somit unmittelbar an eine Batterie 11 anzuschließen. Es sind keine weiteren Bauelemente zwischen der Brückenschaltung 40 und der Batterie 11 vorgesehen. Gegebenenfalls kann eine Sicherung vorhanden sein.

Bestandteil der Brückenschaltung 40 ist die Primärwicklung 41 eines Übertragers 42. Ein Kondensator C2 ist in Reihe zur Sekundärwicklung 43 des Übertragers 42 geschaltet. Die Sekundärwicklung 43 ist Bestandteil einer zweiten Brückenschaltung, nämlich einer hochspannungsseitigen Brückenschaltung 44. Die Brückenschaltung 44 weist ebenfalls vier schaltende Elemente S5 bis S8 auf. Am Ausgang der Brückenschaltung 44 ist ein bidirektionaler Hoch-/Tiefsetzsteller (Buck Boost Converter) 45 vorgesehen, der an den AC/DC-Wandler 3 angeschlossen werden kann. Durch den Übertrager 42 kann die durch die Brückenschaltung 40 erzeugte Wechselspannung hochtransformiert werden. Durch die Brückenschaltung 44 kann diese Spannung wiederum in eine DC-Spannung gewandelt werden, die jedoch höher ist, als die DC-Spannung am Batterieanschluss 8. Eine weitere Anpassung der DC-Spannung kann durch den Hoch-/Tiefsetzsteller (Buck Boost Converter) 45 erfolgen.

Durch die Steuerung 17 kann erkannt werden, wenn ein Fehler in der Brückenschaltung 40 auftritt, insbesondere, wenn ein Kurzschluss oder eine Unterbrechung in der Brückenschaltung 40 vorhanden ist. Insbesondere können Fehlerzustände der einzelnen Schalter S1 bis S4 erkannt werden. Wenn ein Fehler erkannt wird, kann die Brückenschaltung 40 abgeschaltet werden, indem die (nicht dargestellten) Treiber, insbesondere Gatetreiber, der Schalter S1 bis S4 entsprechend angesteuert werden. Somit kann ein Stromfluss von der Hochspannungsseite am Anschluss 46 zur Niederspannungsseite am Batterieanschluss 8 vermieden werden.

Dasselbe Konzept der Fehlerüberwachung und Abschaltung kann für die Brückenschaltung 44 angewendet werden.

Die Fig. 3 zeigt einen Spannungsverlauf der Batteriespannung U_{B}, der durch die erste Messeinrichtung 14 erfasst werden kann und einen Stromverlauf I_{T}, der beispielsweise durch die zweite Messeinrichtung 30 erfasst werden kann. An der Stelle 50 findet ein Einbruch der Spannung U_{B} statt. Zusätzlich erreicht der Strom I_{T} keine negativen Werte mehr. Dieses Muster, d.h. Einbruch der Batteriespannung U_{B} und reduzierter Amplitude des Stroms I_{T} spricht dafür, dass ein Kurzschluss am Schalter S1 oder S3 aufgetreten ist. Wenn ein solches Muster erkannt wird, kann die Brückenschaltung 40 abgeschaltet werden.

In der Fig. 4 sind ebenfalls Spannungs- und Stromverläufe in der Batteriespannung U_{B} und des Stroms I_{T}, gemessen durch die erste und zweite Messeinrichtungen 14 und 30, dargestellt. An der Stelle 51 tritt wiederum ein Fehler auf. Auch in diesem Fall erfolgt ein Spannungseinbruch der Batteriespannung U_{B}. Allerdings erreicht der Strom I_{T} weiterhin negative Werte. Dieses Muster spricht dafür, dass ein Fehler, insbesondere ein Kurzschluss, im Schalter S2 oder S4 aufgetreten ist. Wird ein solches Muster, d.h. ein solcher Verlauf von Batteriespannung U_{B} und Strom I_{T} erkannt, kann ebenfalls eine Abschaltung der Brückenschaltung 40 erfolgen.

## Patentansprüche

1. Redox-Flow-Batteriesystem (1) mit einer Steuerung (17) und einem Batteriewechselrichter (2), der geeignet ist, eine Batterie (11-13) zu laden und/oder zu entladen, wobei der Batteriewechselrichter (2) umfasst:
a. mehrere Batterieanschlüsse (8-10), an die jeweils zumindest eine Batterie (11-13) anschließbar ist;
b. eine erste Messeinrichtung (14-16), die geeignet ist, die Spannung (UB) an einem Batterieanschluss (8-10) zu messen und die mit der Steuerung (17) signaltechnisch verbunden ist;
c. eine zweite Messeinrichtung (30), die geeignet ist, den Strom (IT) an einem Batterieanschluss (8-10) zu messen und die mit der Steuerung (17) signaltechnisch verbunden ist;
d. einen Netzanschluss (4), der an ein Wechselstromversorgungsnetz anschließbar ist, **dadurch gekennzeichnet, dass**
e. der Batteriewechselrichter (2) mehrere DC/DC-Wandler (5, 6, 7) aufweist, von denen zumindest einer eine direkt mit einem Batterieanschluss (8 - 10) verbundene erste Brückenschaltung (40) aufweist, wobei die Steuerung (17) ausgelegt ist, die Brückenschaltung (40) abzuschalten, wenn bei der Überwachung des Stroms (IT) und der Spannung (UB) der entsprechende Stromverlauf und/oder der entsprechende Spannungsverlauf ein vorgegebenes Muster zeigen, welches eindeutig auf einen Defekt oder einen Fehler in der Brückenschaltung (40) hinweist.

2. Redox-Flow-Batteriesystem nach Anspruch 1, **dadurch gekennzeichnet, dass** die erste Brückenschaltung (40) eine Primärwicklung (41) eines Übertragers (42) umfasst, wobei ein Kondensator (C2) in Reihe zu der Sekundärwicklung (43) des Übertragers (42) geschaltet ist.

3. Redox-Flow-Batteriesystem nach einem der vorhergehenden Ansprüche, **dadurch gekennzeichnet, dass** die Sekundärwicklung (43) des Übertragers (42) Bestandteil einer zweiten Brückenschaltung (44) ist.

4. Redox-Flow-Batteriesystem nach einem der vorhergehenden Ansprüche, **dadurch gekennzeichnet, dass** der Batteriewechselrichter (2) eine hochspannungsseitige Brückenschaltung (44) und eine batterieseitige, niederspannungsseitige Brückenschaltung (40) aufweist, so dass durch den Übertrager (42) eine Transformation von der Niederspannungsseite zur Hochspannungsseite erfolgen kann.

5. Redox-Flow-Batteriesystem nach einem der vorhergehenden Ansprüche, **dadurch gekennzeichnet, dass** die Brückenschaltung (40) abschaltbar ist, so dass der Stromfluss von der Hochspannungsseite zur Batterie (11-13) sicher getrennt werden kann.

6. Redox-Flow-Batteriesystem nach einem der vorhergehenden Ansprüche, **dadurch gekennzeichnet, dass** der zumindest eine DC/DC-Wandler (5 - 7) der zweiten Brückenschaltung (44) nachgeordnet einen Hoch-/Tiefsetzsteller (45) aufweist, so dass die Spannung am Ausgang der zweiten Brückenspaltung (44) an der Ausgangsseite des Batteriewechselrichters (2) erhöht werden kann.

7. Redox-Flow-Batteriesystem nach einem der vorhergehenden Ansprüche, **dadurch gekennzeichnet, dass** die Steuerung (17) ausgelegt ist, anhand der durch die erste und zweite Messeinrichtung (14 - 16, 30) gemessenen Spannung und Strom einen Fehler in der ersten Brückenschaltung (40) zu erkennen und diese bei Fehlererkennung abzuschalten.

8. Redox-Flow-Batteriesystem nach einem der vorhergehenden Ansprüche, **dadurch gekennzeichnet, dass** Gatetreiber der Schalter (S1 - S4, S5 - S8) zumindest einer der Brückenschaltungen (40, 44) so ansteuerbar sind, dass die Brückenschaltungen (40, 44) ausgeschaltet werden, so dass ein Stromfluss von der Hochspannungsseite am Anschluss (46) zur Niederspannungsseite am Batterieanschluss (8) vermieden werden kann.

9. Verfahren zum Erkennen eines Fehlers in einer Brückenschaltung (40) eines DC/DC-Wandlers (5 - 7) eines Redox-Flow-Batteriesystems (1) nach einem der vorhergehenden Ansprüche, bei dem Strom (IT) und Spannung (UB) an einem Batterieanschluss (8 - 10) überwacht werden und bei Eintritt eines vorgegebenen Ereignisses die an den Batterieanschluss (8 - 10) angeschlossene Brückenschaltung (40) abgeschaltet wird, wobei Strom (IT) und/oder Spannung (UB) hinsichtlich des Auftretens eines vorgegebenen Musters überwacht werden, welches eindeutig auf einen Defekt oder einen Fehler in der Brückenschaltung (40) hinweist.

10. Verfahren nach Anspruch 9, **dadurch gekennzeichnet, dass** Strom (I_{T}) und/oder Spannung (U_{B}) hinsichtlich des Erreichens eines Schwellwerts überwacht werden.

11. Verfahren nach einem der vorhergehenden Ansprüche 9 oder 10, **dadurch gekennzeichnet, dass** ein Fehler erkannt wird, wenn ein Spannungseinbruch detektiert wird.

12. Verfahren nach einem der vorhergehenden Ansprüche 9 bis 11, **dadurch gekennzeichnet, dass** anhand der gemessenen Strom (I_{T}) und/oder Spannung (U_{B}) bestimmt wird, welcher der Transistoren (S1 - S4) der Brückenschaltung (40) fehlerhaft ist.

13. Verfahren nach einem der vorhergehenden Ansprüche 9 bis 12, **dadurch gekennzeichnet, dass** die Brückenschaltung (40) abgeschaltet wird, indem Gatetreiber, die Transistoren (S1 - S4) der Brückenschaltung (40) zugeordnet sind, abgeschaltet werden.

## Claims

1. Redox flow battery system (1) comprising a controller (17) and a battery inverter (2) that is suitable for charging and/or discharging a battery (11-13), wherein the battery inverter (2) comprises:
a. a plurality of battery terminals (8-10), to each of which at least one battery (11-13) can be connected;
b. a first measuring device (14-16) which is suitable for measuring the voltage (U_{B}) at a battery terminal (8-10) and is connected to the controller (17) by means of signals;
c. a second measuring device (30) which is suitable for measuring the current (I_{T}) at a battery terminal (8-10) and is connected to the controller (17) by means of signals;
d. a mains connection (4) which
can be connected to an AC supply network, **characterized in that**
e. the battery inverter (2) comprises a plurality of DC-to-DC converters (5, 6, 7), at least one of which comprises a first bridge circuit (40) that is directly connected to a battery terminal (8-10), wherein the controller is designed to switch off the bridge circuit (40) if, during monitoring of the current (I_{T}) and the voltage (U_{B}), the corresponding current curve and/or the corresponding voltage curve show/s a predetermined pattern which clearly indicates a defect or an error in the bridge circuit (40).

2. Redox flow battery system according to claim 1, **characterised in that** the first bridge circuit (40) comprises a primary winding (41) of a transformer (42), a capacitor (C2) being in series connection with the secondary winding (43) of the transformer (42).

3. Redox flow battery system according to either of the preceding claims, **characterised in that** the secondary winding (43) of the transformer (42) is part of a second bridge circuit (44).

4. Redox flow battery system according to any one of the preceding claims, **characterised in that** the battery inverter (2) comprises a bridge circuit (44) on the high-voltage side and a bridge circuit (40) on the low-voltage, battery side, such that the transformer (42) can carry out a transformation from the low-voltage side to the high-voltage side.

5. Redox flow battery system according to any one of the preceding claims, **characterised in that** the bridge circuit (40) can be switched off so that the current flow from the high-voltage side to the battery (11-13) can be disconnected safely.

6. Redox flow battery system according to any one of the preceding claims, **characterised in that** the at least one DC-to-DC converter (5-7) of the second bridge circuit (44) comprises a buck-boost converter (45) downstream, so that the voltage at the output of the second bridge circuit (44) on the output side of the battery inverter (2) can be increased.

7. Redox flow battery system according to any one of the preceding claims, **characterised in that** the controller (17) is configured to detect a fault in the first bridge circuit (40) on the basis of the voltage and current measured by the first and second measuring devices (14-16, 30) and to switch said bridge circuit off upon detecting a fault.

8. Redox flow battery system according to any one of the preceding claims, **characterised in that** gate drivers of the switches (S1-S4, S5-S8) of at least one of the bridge circuits (40, 44) can be driven such that the bridge circuits (40, 44) are switched off, and therefore a current flow from the high-voltage side at the terminal (46) to the low-voltage side at the battery terminal (8) can be prevented.

9. Method for detecting a fault in a bridge circuit (40) of a DC-to-DC converter (5-7) of a redox flow battery system (1) according to any one of the preceding claims, in which the current (I_{T}) and voltage (U_{B}) at a battery terminal (8-10) are monitored and the bridge circuit (40) connected to the battery terminal (8-10) is switched off when a predetermined event occurs, wherein the current (I_{T}) and/or voltage (U_{B}) is/are monitored with regard to whether a predetermined pattern has occurred, which clearly indicates a defect or an error in the bridge circuit (40).

10. Method according to claim 9, **characterised in that** the current (I_{T}) and/or voltage (U_{B}) are monitored with regard to whether a threshold value is reached.

11. Method according to any one of the preceding claims 9 or 10, **characterised in that** a fault is detected if a voltage dip is detected.

12. Method according to any one of the preceding claims 9 to 11, **characterised in that** the measured current (I_{T}) and/or voltage (U_{B}) is used to determine which of the transistors (S1-S4) of the bridge circuit (40) is faulty.

13. Method according to any one of the preceding claims 9 to 12, **characterised in that** the bridge circuit (40) is switched off by switching off gate drivers to which transistors (S1-S4) of the bridge circuit (40) are allocated.

## Revendications

1. Système de batterie à flux redox (1) doté d'une commande (17) et d'un onduleur de batterie (2) qui est adapté pour charger et/ou décharger une batterie (11-13), dans lequel l'onduleur de batterie (2) comprend :
a. plusieurs bornes de batterie (8-10) à chacune desquelles peut être connectée au moins une batterie (11-13) ;
b. un premier moyen de mesure (14-16) qui est adapté pour mesurer la tension (UB) au niveau d'une borne de batterie (8-10) et qui est relié par une technique de signal à la commande (17) ;
c. un second moyen de mesure (30) qui est adapté pour mesurer le courant (IT) au niveau d'une borne de batterie (8-10) et qui est relié par une technique de signal à la commande (17) ;
d. une borne de raccordement au réseau (4) qui peut être reliée à un réseau d'alimentation en courant alternatif, **caractérisé en ce que**
e. l'onduleur de batterie (2) comporte plusieurs convertisseurs continu/continu (5, 6, 7) dont au moins un comporte un premier circuit en pont (40) relié directement à une borne de batterie (8-10), dans lequel la commande (17) est conçue pour désactiver le circuit en pont (40) si, lors de la surveillance du courant (IT) et de la tension (UB), la caractéristique de courant correspondante et/ou la caractéristique de tension correspondante présentent un motif prédéterminé qui indique de manière évidente un défaut ou une erreur dans le circuit en pont (40).

2. Système de batterie à flux redox selon la revendication 1, **caractérisé en ce que** le premier circuit en pont (40) comprend un enroulement primaire (41) d'un transformateur (42), dans lequel un condensateur (C2) est connecté en série avec l'enroulement secondaire (43) du transformateur (42).

3. Système de batterie à flux redox selon l'une des revendications précédentes, **caractérisé en ce que** l'enroulement secondaire (43) du transformateur (42) fait partie d'un second circuit en pont (44).

4. Système de batterie à flux redox selon l'une des revendications précédentes, **caractérisé en ce que** l'onduleur de batterie (2) comporte un circuit en pont (44) côté haute tension et un circuit en pont (40) côté batterie, côté basse tension, de sorte qu'une transformation du côté basse tension vers le côté haute tension peut être effectuée par le transformateur (42).

5. Système de batterie à flux redox selon l'une des revendications précédentes, **caractérisé en ce que** le circuit en pont (40) peut être désactivé de manière à ce que le flux de courant allant du côté haute tension vers la batterie (11-13) puisse être interrompu en toute sécurité.

6. Système de batterie à flux redox selon l'une des revendications précédentes, **caractérisé en ce que** ledit au moins un convertisseur continu/continu (5-7) du second circuit en pont (44) comporte un convertisseur élévateur/abaisseur (45) disposé en aval du second circuit en pont (44), de sorte que la tension à la sortie du second circuit en pont (44) peut être augmentée au niveau du côté sortie de l'onduleur de batterie (2).

7. Système de batterie à flux redox selon l'une des revendications précédentes, **caractérisé en ce que** la commande (17) est adaptée pour identifier un défaut dans le premier circuit en pont (40) sur la base de la tension et du courant mesurés par les premier et second moyens de mesure (14-16, 30) et pour le désactiver lors de l'identification d'un défaut.

8. Système de batterie à flux redox selon l'une des revendications précédentes, **caractérisé en ce que** des circuits d'attaque de grille des commutateurs (S1 - S4, S5 - S8) d'au moins l'un des circuits en pont (40, 44) peuvent être commandés de manière à désactiver les circuits en pont (40, 44), de sorte qu'un flux de courant allant du côté haute tension au niveau de la borne (46) vers le côté basse tension au niveau de la borne de batterie (8) peut être évité.

9. Procédé pour détecter un défaut dans un circuit en pont (40) d'un convertisseur continu/continu (5 - 7) d'un système de batterie à flux redox (1) selon l'une des revendications précédentes, dans lequel le courant (IT) et la tension (UB) au niveau d'une borne de batterie (8 - 10) sont surveillés et lorsqu'un événement prédéterminé se produit, le circuit en pont (40) relié à la borne de batterie (8 - 10) est désactivé, dans lequel le courant (IT) et/ou la tension (UB) sont surveillés pour déterminer s'il se produit un motif prédéterminé qui indique clairement un défaut ou une erreur dans le circuit en pont (40).

10. Procédé selon la revendication 9, **caractérisé en ce que** le courant (I_{T}) et/ou la tension (U_{B}) sont surveillés pour déterminer si une valeur de seuil est atteinte.

11. Procédé selon l'une des revendications 9 ou 10 précédentes, **caractérisé en ce qu'**un défaut est identifié lorsqu'une chute de tension est détectée.

12. Procédé selon l'une des revendications 9 à 11 précédentes, **caractérisé en ce qu'**il est déterminé, sur la base du courant (I_{T}) et/ou de la tension (U_{B}) mesurés, lequel des transistors (S1 - S4) du circuit en pont (40) est défectueux.

13. Procédé selon l'une des revendications 9 à 12 précédentes, **caractérisé en ce que** le circuit en pont (40) est désactivé par désactivation des circuits d'attaque de grille associés aux transistors (S1 - S4) du circuit en pont (40).
